# EUROPÄISCHE PATENTSCHRIFT

(11) **EP 0 771 421 B1**
(45) Veröffentlichungstag und Bekanntmachung des Hinweises auf die Patenterteilung: **03.06.1998**
(21) Anmeldenummer: 95925709.8
(22) Anmeldetag: 14.07.1995
(51) Int. Cl.: G01R 15/06, G01R 15/16

(54) **SPANNUNGSWANDLER FÜR EINE METALLGEKAPSELTE ELEKTRISCHE SCHALTANLAGE**
VOLTAGE TRANSFORMER FOR METAL-CLAD ELECTRIC SWITCHGEAR
TRANSFORMATEUR DE TENSION POUR INSTALLATION DE COMMUTATION ELECTRIQUE A BLINDAGE METALLIQUE

(30) Priorität: 19.07.1994 DE 4426699
(43) Veröffentlichungstag der Anmeldung: 07.05.1997
(73) Patentinhaber: SIEMENS AKTIENGESELLSCHAFT, 80333 München (DE)
(72) Erfinder: GORABLENKOW, Jörg, D-13591 Berlin (DE); LORENZ, Dieter, D-12207 Berlin (DE); SCHÖPS, Jürgen, D-10717 Berlin (DE)
(86) Internationale Anmeldenummer: DE9500955
(87) Internationale Veröffentlichungsnummer: WO9602843

(56) Entgegenhaltungen:
- DE-A- 622 814
- DE-A- 2 325 447
- DE-A- 2 409 595
- DE-A- 3 145 255
- DE-U- 9 310 388
- FR-A- 2 108 875

## Beschreibung

Die Erfindung bezieht sich auf einen Spannungswandler für eine metallgekapselte elektrische Schaltanlage, der eine einen Hochspannungsleiter umgebende Meßelektrode und eine die Meßelektrode koaxial umgebende, gegenüber der Meßelektrode mittels einer Isolierstoffschicht isolierte Außenelektrode aufweist, wobei ein kapazitiver Spannungsteiler mit einem zwischen dem Hochspannungsleiter und der Meßelektrode gebildeten Hochspannungskondensator und einem zwischen der Meßelektrode und der Außenelektrode gebildeten Niederspannungskondensator vorgesehen ist, wobei die Isolierstoffschicht (6) den Zwischenraum zwischen der Meßelektrode (4) und der Außenelektrode (3) ausfüllt und wobei die Außenelektrode innerhalb eines Kapselungsrohres der Schaltanlage mit Abstand zu diesem angeordnet ist.

Ein derartiger Spannungswandler ist beispielsweise aus der DE-OS 24 09 595 bekannt. Dort ist ein Spannungswandler mit einer Meßelektrode und einer Außenelektrode beschrieben, die jeweils als Metallkaschierung einer Leiterplatte ausgeführt sind. Die Leiterplatte dient dort als Träger für den Spannungswandler und wird innerhalb der Metallkapselung der Schaltanlage gehaltert.

Es ergibt sich die Schwierigkeit, handelsübliche Leiterplatten in eine zylindrische Form zu bringen sowie das Problem, daß die Dicke der Isolation zwischen Außenelektrode und Meßelektrode nicht frei wählbar ist und daß die Abschlußkanten der Metallkaschierungen, die die Elektroden bilden, scharfkantig sind, so daß an diesen Stellen leicht Überschlage stattfinden können bzw. die dielektrische Festigkeit zumindest verringert ist.

Aus der DE-OS 20 35 553 ist ein Ringkern-Stromwandler bekannt, dessen Tragrohr für die Ringkerne aus zwei einander überlappenden Teilrohren besteht, die mittels einer Isolierstoffschicht voneinander getrennt sind. Dort besteht jedoch nicht die Notwendigkeit, die Teilrohre voneinander vollständig galvanisch zu trennen. Es ist lediglich notwendig, eine die Ringkerne umgebende Leiterschleife zu unterbrechen.

Aus der EP-0 622 814 A1, die unter Artikel 54(3) EPÜ fällt, ist ein Spannungswandler für eine elektrische Hochspannungsschaltanlage bekannt, bei dem eine Elektrode tragend einstückig mit einem Flansch der Kapselung verbunden ist.

Der vorliegenden Erfindung liegt die Aufgabe zugrunde, einen Spannungswandler der eingangs genannten Art so zu gestalten, daß er einfach und kostengünstig herstellbar ist und die Anforderungen an die dielektrische Festigkeit innerhalb der Schaltanlage erfüllt.

Die Aufgabe wird erfindungsgemäß dadurch gelöst, daß die Außenelektrode einstückig tragend mit einem Flansch der Metallkapselung der Schaltanlage verbunden ist und daß die Meßelektrode mittels eines zwischen diese und die Außenelektrode eingegossenen, die Isolierschicht bildenden Gießharzes tragend mit der Außenelektrode verbunden ist.

Der erfindungsgemäße Spannungswandler kann beispielsweise dadurch hergestellt werden, daß zunächst Außenelektrode und Meßelektrode koaxial zueinander mittels einer Zentriervorrichtung positioniert werden und zwar so, daß der zylindrische Zwischenraum zwischen Außenelektrode und Meßelektrode überall am Umfang gleich groß ist und daß danach in diesen Zwischenraum ein Gießharz eingegossen wird, das die Außenelektrode mit der Meßelektrode verklebt, gleichzeitig als Abstandhalter und Isolierstoff zwischen der Meßelektrode und der Außenelektrode wirkt und zusätzlich vorteilhaft eine hohe Dielektritätskonstante aufweist, um eine hohe elektrische Kapazität zwischen der Außenelektrode und der Meßelektrode zu erzielen.

Die Außenelektrode kann dabei Teil eines größeren Bauteils, beispielsweise eines Rohres sein, das mit einem Gehäuseflansch der gekapselten Schaltanlage einstückig verbunden ist. Durch diesen Flansch kann dann auch vorteilhaft der Meßanschluß für den Spannungswandler isoliert durchgeführt sein. Außerdem können sowohl an der Außenelektrode als auch an der Meßelektrode an den dielektrisch besonders belasteten Stellen, beispielsweise an den beiden Enden des Spannungswandlers jeweils Abschirmelektroden angeformt sein. Der Spannungswandler muß auch nicht zylindrisch ausgebildet sein, wobei sich jedoch eine zylindersymmetrische Anordnung, beispielsweise eine doppelkegelige Anordnung anbietet.

Die Erfindung kann außerdem vorteilhaft ausgestaltet sein durch eine einstückig mit der Meßelektrode verbundene Abschirmelektrode, die an dem freien, nicht mit dem Flansch verbundenen Ende des Spannungswandlers angeordnet ist.

Hierdurch wird der Raum zwischen der Meßelektrode und dem diese durchsetzenden Hochspannungsleiter dielektrisch günstig gestaltet.

Die Erfindung kann vorteilhaft auch dadurch ausgestaltet werden, daß der ringförmige Zwischenraum zwischen der Meßelektrode und der Außenelektrode unter Abdichtung an einem seiner Enden mittels eines im Querschnitt kreisförmigen Dichtungsrings mit Gießharz ausgegossen ist.

Das Gießharz, das beim Eingießen in den Zwischenraum zwischen der Meßelektrode und der Außenelektrode leicht flüssig ist, muß am Auslaufen aus diesem Zwischenraum gehindert werden, bis daß es erstarrt ist. Zu diesem Zweck wird ein im Querschnitt kreisförmiger Dichtungsring an der Innenseite der Außenelektrode in die Fuge gedrückt, die zwischen dem Ende der Meßelektrode und der Außenelektrode gebildet wird. Der Durchmesser des Dichtungsrings ist günstigerweise größer als die lichte Weite des Zwischenraums zwischen der Meßelektrode und der Außenelektrode, so daß der Dichtungsring nicht in den Zwischenraum hineinrutscht, sondern nach dem Erhärten des Gießharzes im dem Zwischenraum eine umlaufende Rinne als seinen Negativabdruck hinterläßt. Durch diese Rinne ist ein dielektrisch günstiger Übergang zwischen den drei Materialien der Meßelektrode, des Gießharzes und eines eventuell vorhandenen Isoliergases der elektrischen Schaltanlage erreicht. Außerdem ist dieser Bereich dann derart gestaltet, daß sich dort kaum Fremdpartikel ansammeln können, die dielektrische Störungen verursachen würden. Dieser Bereich kann nach einer Bearbeitung oder Montage einfach gereinigt werden.

Um eine gute Dichtung beim Eingießen des Gießharzes zu erreichen, bietet es sich an, beispielsweise einen Dichtungsring aus einem Elastomer, insbesondere einer Gummimischung zu verwenden.

Die Erfindung kann besonders vorteilhaft auch so gestaltet werden, daß die Außenelektrode zusätzlich einen oder mehrere Ringkerne eines Ringkernstromwandlers trägt.

Dadurch können Strom und Spannungswandler als konstruktive Einheit besonders platzsparend in der Schaltanlage angeordnet und auch mit geringem Aufwand zusammen montiert werden. Dadurch, daß für beide Wandler zusammen nur eine Tragkonstruktion benötigt wird, werden zusätzlich die Kosten verringert. Die Ringkerne des Ringkernstromwandlers können beispielsweise mittels eines Gießharzes mit der Außenelektrode vergossen sein. Die Ringkerne können beispielsweise beim Verguß der Meßelektrode und der Außenelektrode des Spannungswandlers gleich mitvergossen werden.

Die Erfindung bezieht sich außerdem auf ein Verfahren zur Herstellung eines Spannungswandlers, wie oben beschrieben, bei dem der Zwischenraum zwischen der Meßelektrode und der Außenelektrode mittels eines im Querschnitt kreisförmigen Dichtungsringes abgedichtet und mit einem Gießharz ausgegossen wird.

Im folgenden wird die Erfindung anhand eines Ausführungsbeispiels in einer Zeichnung gezeigt und anschließend beschrieben.

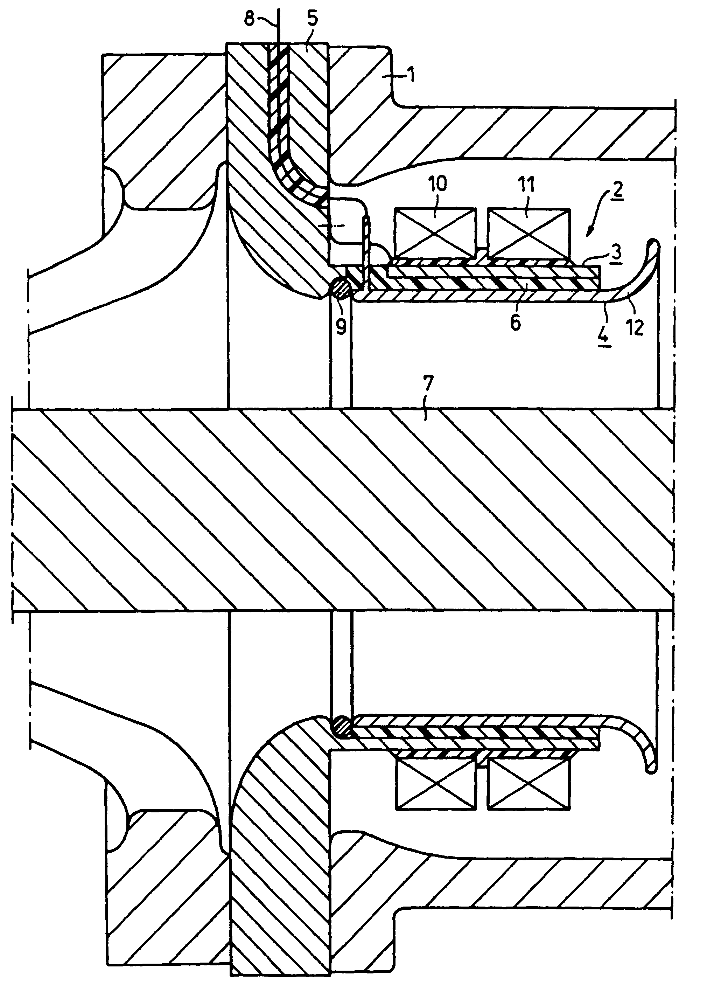

Dabei zeigt die Figur schematisch im Längsschnitt einen Teil einer gekapselten Schaltanlage mit einem kombinierten Strom/Spannungswandler, der mit einem Gießharz vergossen ist, wobei der Dichtungsring zum Abdichten des Zwischenraums zwischen der Meßelektrode und der Außenelektrode des Spannungswandlers noch nicht entfernt ist.

In die metallische Kapselung 1 einer Hochspannungsschaltanlage ist ein kombinierter Strom/Spannungswandler 2 eingebaut. Dieser wird von einer Außenelektrode 3 des Spannungswandlers 3, 4 getragen, die einstückig mit einem Flansch 5 der Metallkapselung ausgeführt ist. In die Außenelektrode 3 ist mit Abstand eine Meßelektrode 4 eingeschoben, die mit der Außenelektrode 3 mittels eines Gießharzes 6 vergossen ist. Das Gießharz dient sowohl zur Verklebung der Meßelektrode 4 mit der Außenelektrode 3 als auch als Dielektrikum des zwischen der Außenelektrode 3 und der Meßelektrode 4 gebildeten Kondensators, der den Unterspannungskondensator eines kapazitiven Spannungsteilers bildet, dessen Hochspannungskondensator zwischen der Meßelektrode 4 und dem Hochspannungleiter 7 gebildet ist. Durch diese kapazitive Spannungsteilung ist zwischen der Meßelektrode 4 und der Außenelektrode 3 eine Spannung im Niederspannungsbereich abgreifbar, die proportional zu der Spannung zwischen dem Hochspannungsleiter 7 und der Außenelektrode 3 ist, welche mit Erdpotential verbunden ist.

Eine Variante besteht darin, den Strom durch den Hochspannungskondensator zwischen dem Hochspannungsleiter 7 und der Meßelektrode 4 zu messen, welcher proportional zu der an dem Hochspannungsleiter anliegenden Hochspannung ist.

In diesem Fall hat der Niederspannungskondensator die Funktion, hochfrequente Überspannungen abzuleiten. Der Niederspannungskondensator, der zwischen der Meßelektrode 4 und der Außenelektrode 3 gebildet ist, hat für hohe Frequenzen eine geringere Impedanz, als die nicht dargestellte Strommeßeinrichtung, die an den Hochspannungskondensator angeschlossen ist.

Ein Meßanschluß 8 des so gebildeten Spannungswandlers ist isoliert durch den Flansch 5 durchgeführt.

Beim Verguß der Meßelektrode 4 mit der Außenelektrode 3 ist der am Ende der Meßelektrode 4 angeordnete Eingangsbereich des Zwischenraums zwischen den Elektroden mittels eines Dichtungsrings 9 aus einem Elastomer abgedichtet. Dadurch ergibt sich nach Entfernen des Dichtungsrings 9 eine rinnenförmige Kontur des erhärteten Gießharzes 6 in diesem Bereich

Auf die Außenelektrode 3 sind zwei Ringkerne 10, 11 eines Stromwandlers aufgesetzt, die jeweils eine nicht dargestellte Sekundärwicklung aufweisen, in der bei einem Stromfluß durch den Hochspannungsleiter 7 ein entsprechender Sekundärstrom induziert wird. Die Ausleitung dieses Signals aus der Metallkapselung der Schaltanlage ist nicht weiter dargestellt. Die Ringkerne 10, 11 sind mittels eines Gießharzes, mit dem die Meßelektrode 4 und die Außenelektrode 3 vergossen sind, mit der Außenelektrode 3 verbunden.

Die Meßelektrode 4 weist eine Abschirmelektrode 12 auf, die die Meßelektrode 4 dielektrisch abschirmt.

Die Abschirmelektrode 12 kann bis fast an die Metallkapselung 1 heranreichen, um einen abgeschirmten Bereich für die Ringkerne 10, 11 des Stromwandlers zu bilden.

## Patentansprüche

1. Spannungswandler (3, 4, 6) für eine metallgekapselte elektrische Schaltanlage, der eine einen Hochspannungsleiter (7) umgebende Meßelektrode (4) und eine die Meßelektrode (4) koaxial umgebende, gegenüber der Meßelektrode (4) mittels einer Isolierstoffschicht (6) isolierte Außenelektrode (3) aufweist, wobei ein kapazitiver Spannungsteiler mit einem zwischen dem Hochspannungsleiter (7) und der Meßelektrode (4) gebildeten Hochspannungskondensator und einem zwischen der Meßelektrode (4) und der Außenelektrode (3) gebildeten Niederspannungskondensator vorgesehen ist, wobei die Isolierstoffschicht (6) den Zwischenraum zwischen der Meßelektrode (4) und der Außenelektrode (3) ausfüllt und wobei die Außenelektrode (3) innerhalb eines Kapselungsrohres der Schaltanlage mit Abstand zu diesem angeordnet ist,
**dadurch gekennzeichnet,** daß die Außenelektrode (3) einstückig tragend mit einem Flansch (5) der Metallkapselung der Schaltanlage verbunden ist und daß die Meßelektrode (4) mittels eines zwischen diese und die Außenelektrode (3) eingegossenen, die Isolierstoffschicht bildenden Gießharzes (6) tragend mit der Außenelektrode (3) verbunden ist.

2. Spannungswandler nach Anspruch 1,
**gekennzeichnet durch** eine einstückig mit der Meßelektrode (4) verbundene Abschirmelektrode (12), die an dem freien, nicht mit dem Flansch (5) verbundenen Ende des Spannungswandlers (3, 4, 6) angeordnet ist.

3. Spannungswandler nach Anspruch 1 oder 2,
**dadurch gekennzeichnet,** daß der ringförmige Zwischenraum zwischen der Meßelektrode (4) und der Außenelektrode (3) unter Abdichtung an einem seiner Enden mittels eines im Querschnitt kreisförmigen Dichtungsringes (9) mit Gießharz (6) ausgegossen ist.

4. Spannungswandler nach Anspruch 1, 2 oder 3,
**dadurch gekennzeichnet,** daß die Außenelektrode zusätzlich einen oder mehrere Ringkerne eines Ringkernstromwandlers trägt.

5. Verfahren zur Herstellung eines Spannungswandlers nach einem der Ansprüche 1 bis 4,
**dadurch gekennzeichnet,** daß der Zwischenraum zwischen der Meßelektrode (4) und der Außenelektrode (3) mittels eines im Querschnitt kreisförmigen Dichtungsringes (9) abgedichtet und mit einem Gießharz (6) ausgegossen wird.

## Claims

1. Voltage converter (3, 4, 6) for a metal-enclosed electrical switch gear assembly, which has a measurement electrode (4) surrounding a high-voltage conductor (7) and has an outer electrode (3) which coaxially surrounds the measurement electrode (4) and is insulated from the measurement electrode (4) by means of a dielectric material layer (6), a capacitive voltage divider being provided, having a high-voltage capacitor formed between the high-voltage conductor (7) and the measurement electrode (4) and having a low-voltage capacitor formed between the measurement electrode (4) and the outer electrode (3), the dielectric material layer (6) filling the intermediate area between the measurement electrode (4) and the outer electrode (3), and the outer electrode (3) being arranged within an enclosure tube of the switch gear assembly and at a distance from said tube, characterized in that the outer electrode (3) is integrally connected in a load-bearing manner to a flange (5) of the metal enclosure of the switch gear assembly, and in that the measurement electrode (4) is connected in a load-bearing manner to the outer electrode (3) by means of a resin casting (6) which is cast between said measurement electrode (4) and the outer electrode (3) and forms the dielectric material layer.

2. Voltage converter according to Claim 1, characterized by a screening electrode (12) which is integrally connected to the measurement electrode (4) and is arranged at the free end, which is not connected to the flange (5), of the voltage converter (3, 4, 6).

3. Voltage converter according to Claim 1 or 2, characterized in that the annular intermediate area between the measurement electrode (4) and the outer electrode (3) is filled by the resin casting (6), sealed at one of its ends by means of a sealing ring (9) having a circular cross-section.

4. Voltage converter according to Claim 1, 2 or 3, characterized in that the outer electrode is additionally fitted with one or more toroidal cores of a toroidal-core current transformer.

5. Method for producing a voltage converter according to one of Claims 1 to 4, characterized in that the intermediate area between the measurement electrode (4) and the outer electrode (3) is sealed by means of a sealing ring (9) having a circular cross-section, and is filled with a resin casting (6).

## Revendications

1. Transformateur (3, 4, 6) de tension pour une installation de coupure électrique à blindage métallique, qui comporte une électrode (4) de mesure entourant un conducteur (7) haute tension et une électrode (3) extérieure entourant coaxialement l'électrode (4) de mesure, et isolé de l'électrode (4) de mesure au moyen d'une couche (6) en matériau isolant, un diviseur de tension capacitive, comportant un condensateur haute tension formé entre le conducteur (7) haute tension et l'électrode (4) de mesure et un condensateur basse tension formé entre l'électrode (4) de mesure et l'électrode (3) extérieure étant prévu, la couche (6) en matériau isolant remplissant totalement l'intervalle entre l'électrode (4) de mesure et l'électrode (3) extérieure et l'électrode (3) extérieure étant montée à l'intérieur d'un tube de blindage de l'installation de coupure, à distance de ce tube, caractérisé en ce que l'électrode (3) extérieure est reliée d'un seul tenant, de manière porteuse, à une bride (5) du blindage métallique de l'installation de coupure et en ce que l'électrode (4) de mesure est reliée, de manière porteuse, à l'électrode (3) extérieure au moyen d'une résine (6) de coulée versée entre l'électrode (4) de mesure et l'électrode (3) extérieure et formant la couche en matériau isolant.

2. Transformateur de tension suivant la revendication 1, caractérisé par une électrode (12) de protection qui est reliée d'un seul tenant à l'électrode (4) de mesure et qui est montée à l'extrémité libre, qui n'est pas reliée à la bride (5), du transformateur (3, 4, 6) de tension.

3. Transformateur de tension suivant la revendication 1 ou 2, caractérisé en ce que l'espace annulaire entre l'électrode (4) de mesure et l'électrode (3) extérieure est rempli de résine (6) de coulée en rendant étanche l'une de ses extrémités au moyen d'un joint (9) d'étanchéité de section transversale circulaire.

4. Transformateur de tension suivant la revendication 1,2 ou 3, caractérisé en ce que l'électrode extérieure porte, de plus, un noyau toroïdal ou plusieurs noyaux toroïdaux d'un transformateur de courant toroïdal.

5. Procédé de fabrication d'un transformateur de tension suivant l'une des revendications 1 à 4,
caractérisé en ce qu'on rend étanche l'intervalle entre l'électrode (4) de mesure et l'électrode (3) extérieure au moyen d'un joint d'étanchéité de section transversale circulaire et on le remplit d'une résine de coulée.
